# EUROPEAN PATENT APPLICATION

(11) **EP 4 597 577 A1**
(43) Date of publication of application: **06.08.2025**
(21) Application number: 24186407.3
(22) Date of filing: 04.07.2024
(51) Int. Cl.: H01L 29/778, H01L 29/10, H01L 29/40, H01L 29/423

(54) **DEVICE WITH OUTER CONDUCTIVE SPACER**

(30) Priority: 30.01.2024 US 202418427206
(71) Applicant: GlobalFoundries U.S. Inc., Malta, NY 12020 (US)
(72) Inventor: HEBERT, Francois, Santa Clara, CA 95054 (US); SUSAI, Lawrence Selvaraj, Essex Junction, VT 05452 (US); BENTLEY, Steven John, Malta, NY 12020 (US)
(74) Representative: Lambacher, Michael

(57) **Abstract**

The present disclosure relates to semiconductor structures and, more particularly, to devices with an outer conductive spacer and methods of manufacture. The structure includes: a gate structure; a gate metal connecting to the gate structure; inner spacers contacting and surrounding the gate metal; a passivation layer on the inner spacers; and outer conductive spacers on the passivation layer and adjacent to sides of the gate structure.

## Description

### BACKGROUND

This invention was made with government support under Contract # HQ0727790700 awarded by the Defense Microelectronics Activity (DMEA). The government has certain rights in the invention.

The present disclosure relates to semiconductor structures and, more particularly, to devices with an outer conductive spacer and methods of manufacture.

A high-electron-mobility transistor (HEMT) is a field-effect transistor incorporating a junction between two materials with different band gaps (i.e. a heterojunction) as the channel, instead of a doped region (as is generally the case for a MOSFET). Commonly used material families are GaN or GaAs, although other materials can be used, dependent on the application of the device.

Due to the higher critical field and switching figures of merit of the GaN materials system, GaN HEMT devices typically have a higher electric-field strength than silicon MOSFETS, providing substantial performance improvements in, for example, on-resistance and breakdown voltage, while offering fast switching speed, amongst other important parameters. Since these properties result in fundamentally higher system efficiency, HEMTs may be used in diverse power management applications, such as AC-DC and DC-DC conversion in the consumer or automotive space. In RF applications, they may be used in high frequency power amplifiers, low noise amplifiers or switches in such applications as cell phones, satellite or receivers or radar equipment.

### SUMMARY

In an aspect of the disclosure, a structure comprises: a gate structure; a gate metal connecting to the gate structure; inner spacers contacting and surrounding the gate metal; a passivation layer on the inner spacers; and outer conductive spacers on the passivation layer and adjacent to sides of the gate structure.
Additional features of the structure are set forth in dependent claims 2 to 9.

In an aspect of the disclosure, a structure comprises: a gate structure; inner dielectric spacers; outer conductive spacers surrounding the inner dielectric spacers; a gate metal connecting to the gate structure and surrounded by the inner dielectric spacers, the gate metal also being adjacent to the outer conductive spacers on an opposing side from the inner dielectric spacers.
Additional features of the structure are set forth in dependent claims 11 to 14.

In an aspect of the disclosure, a method comprises: forming a gate structure; forming a gate metal connecting to the gate structure; forming inner spacers contacting and surrounding the gate metal; forming a passivation layer on the inner sidewall spacers; and forming outer conductive spacers on the passivation layer and adjacent to sides of the gate structure.

### BRIEF DESCRIPTION OF THE DRAWINGS

The present disclosure is described in the detailed description which follows, in reference to the noted plurality of drawings by way of non-limiting examples of exemplary embodiments of the present disclosure.
FIG. 1 shows a structure and respective fabrication processes in accordance with aspects of the present disclosure.
FIG. 2 shows a structure in accordance with additional aspects of the present disclosure.
FIGS. 3A-3C show top views of the outer conductive spacers, amongst other features, in accordance with aspects of the present disclosure.
FIGS. 4A-4D show fabrication processes for manufacturing the structure of FIG. 1 in accordance with aspects of the present disclosure.

### DETAILED DESCRIPTION

The present disclosure relates to semiconductor structures and, more particularly, to devices with an outer conductive spacer and methods of manufacture. More specifically, the device may be an enhancement mode (e.g., normally-off) high-electron-mobility transistor (HEMT) with inner dielectric spacers, outer conductive spacers and a field plate comprising a gate metal. In embodiments, the outer conductive spacers may be a field plate connecting to a source of the device. Advantageously, the devices may be scalable enhancement mode devices, necessary for high performance GaN power technologies. In embodiments, for example, the devices can be scalable to very short lengths to minimize channel resistance, particularly when operating voltage is reduced. In addition, the methods described herein may reduce stress on the edges of the p-GaN gate structure (e.g., during formation of a gate metal process).

In more specific embodiments, the HEMT may be a high-voltage p-GaN HEMT with a self-aligned spacer-based structure for a p-GaN gate structure, e.g., gate electrode, of an e-mode GaN HEMT device. In embodiments, the self-aligned approach is based on the use of inner dielectric spacers and outer conductive spacers, with a gate metal precisely aligned to the gate structure without causing stress or shorts. The outer conductive spacers may be used as a field plate connecting to a source of the device, in addition to protecting the gate structure and a passivation layer, e.g., formed by atomic layer deposition (ALD), during metal gate deposition processes.

The structures of the present disclosure can be manufactured in a number of ways using a number of different tools. In general, though, the methodologies and tools are used to form structures with dimensions in the micrometer and nanometer scale. The methodologies, i.e., technologies, employed to manufacture the structures of the present disclosure have been adopted from integrated circuit (IC) technology. For example, the structures are built on wafers and are realized in films of material patterned by photolithographic processes on the top of a wafer. In particular, the fabrication of the structures uses three basic building blocks: (i) deposition of thin films of material on a substrate, (ii) applying a patterned mask on top of the films by photolithographic imaging, and (iii) etching the films selectively to the mask. In addition, precleaning processes may be used to clean etched surfaces of any contaminants, as is known in the art. Moreover, when necessary, rapid thermal anneal processes may be used to drive-in dopants or material layers as is known in the art.

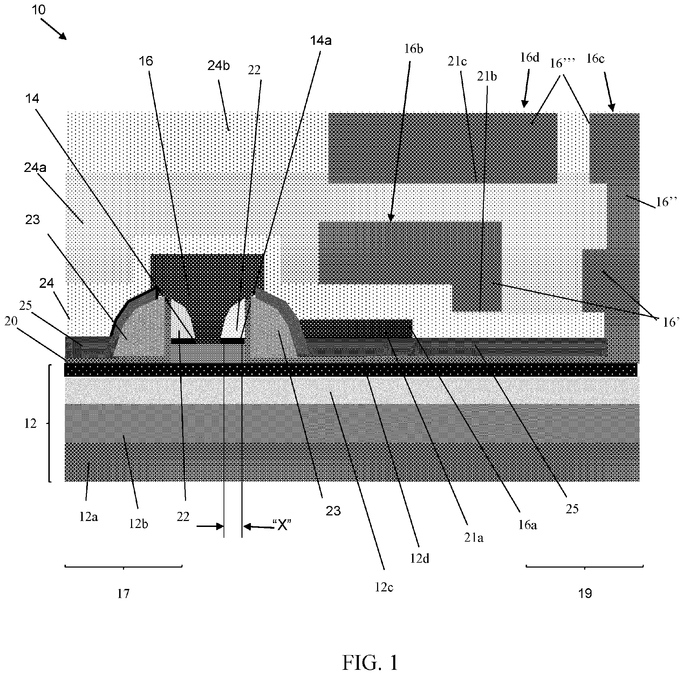

FIG. 1 shows a structure and respective fabrication processes in accordance with aspects of the present disclosure. More specifically, the structure 10 of FIG. 1 may be a HEMT including a p-GaN gate structure 14 with a gate metal 16 surrounded by inner dielectric spacers 22 and outer conductive spacers 23. The outer conductive spacers 23 may be used as a field plate connecting to a source 17. It should be recognized that field plate 21a may be an independent field plate that may be formed from the gate metal. Also, in embodiments, although the field plates may be connected to the source 17, there are other applications in which the field plates may be connected to the gate in other applications.

A passivation layer 20 may be provided between the inner dielectric spacers 22 and the outer conductive spacers 23, with another passivation layer (insulator material) 25 covering the outer conductive spacers 23 and the passivation layer 20. In embodiments, the outer conductive spacers 23 will protect the p-GaN gate structure 14 during subsequent fabrication processes, e.g., forming field plates and depositing of gate metal, in addition to reducing process variations and the electric field when a voltage is applied to a drain side 19 of the device. A gate metal 16a may be formed over the passivation layer 25 on an outer side of the outer conductive spacers 23. The passivation layer 25 will isolate the gate metal 16a from the outer conductive spacers 23. It should be understood that there may be an additional field plate 21a, which may be connected to the source 17. The gate metal 16a may be used as a self-aligned field plate 21a (e.g., gate metal field plate) connecting the source 17.

More specifically, the structure 10 includes a semiconductor substrate 12. The semiconductor substrate 12 may comprise a semiconductor substrate 12a comprising Si; although other suitable materials are contemplated herein including, but not limited to, SiGe, SiGeC, SiC, GaN, AlN, GaAs, InAs, InP, and other III-V or II-VI compound semiconductors, or may be an engineered substrate with multiple layers, such as silicon-on-insulator (SOI). In preferred embodiments, the semiconductor material substrate may comprise a suitable crystal orientation, e.g., <111> in the case of silicon.

The remaining semiconductor materials 12b-12d may be a stack of semiconductor material used to form a GaN HEMT device. By way of illustrative and non-limiting example, a wide-bandgap semiconductor layer 12b may be, for example, an AlGaN stack of materials as is known in the art. For example, and as a non-limiting illustrative example, the wide-bandgap semiconductor layer 12b may comprise, in a layered stack of semiconductor materials, a seed layer, e.g., AlN, on the underlying semiconductor substrate 12a, with a buffer layer (e.g., AlGaN/GaN superlattice) and a channel layer 12c, e.g., GaN. In embodiments, the channel layer 12c may be undoped GaN formed over the wide-bandgap semiconductor layer 12b, with a barrier layer 12d, which may be AlGaN, formed over the undoped GaN. In other embodiments, the layer 12d may be AlN, InAlN, InGaN, GaN or multiple materials.. The stack of semiconductor materials may be formed by conventional epitaxial growth processes or other known deposition methods, e.g., metal-organic chemical vapor deposition (MOCVD) or molecular beam epitaxy (MBE).

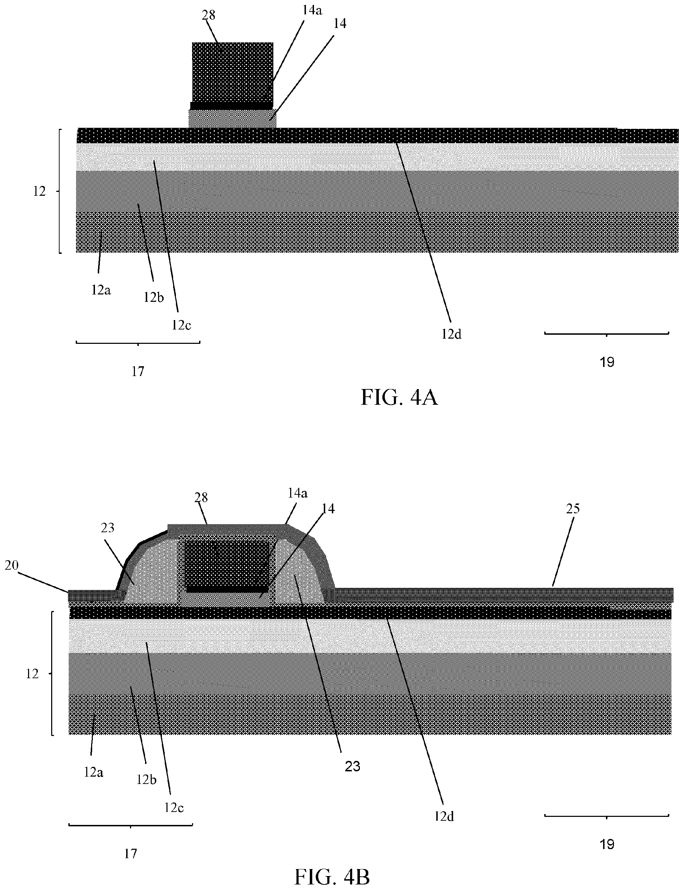

A p-doped GaN layer may be formed over the barrier layer 12d, which is patterned to form the p-GaN gate structure 14. An optional undoped thin GaN layer or Si₃N₄ material may be provided on the surface of the p-GaN gate structure 14 as shown at reference numeral 14a. This additional passivation layer 14a acts as an etch stop as described with respect to FIGS. 4A-4D. The passivation layer 14a may be formed by any conventional deposition method, e.g., CVD or ALD, and patterned with the gate material using conventional lithography and etching processes as known in the art such that no further explanation is required for a complete understanding of the present disclosure.

Still referring to FIG. 1, the device 10 (e.g., including p-GaN gate structure 14) may be provided over the channel layer 12c and barrier layer 12d. For example, the device 10 may include a source region 17 and a drain region 19 of the channel layer 12c and/or layer 12d. Portions of the semiconductor material may be epitaxially grown with an in-situ doping, e.g., p-type doping such as magnesium (Mg), as is known in the art.

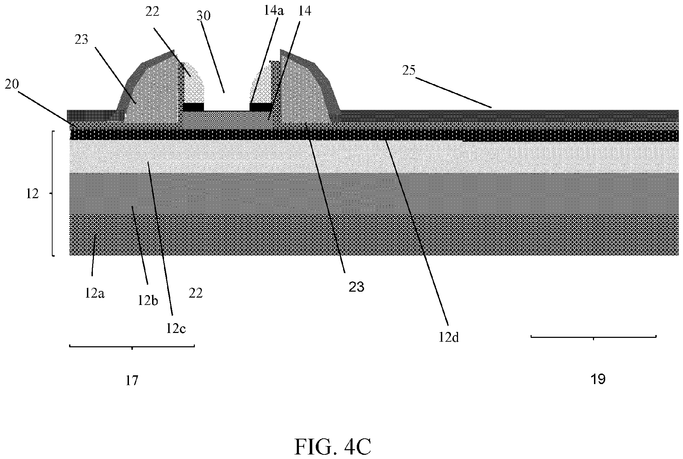

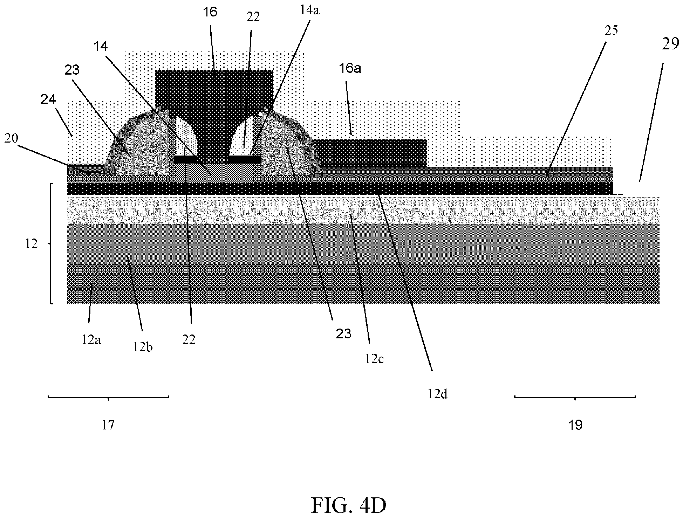

A gate metal 16, e.g., TiN, TiAl and/or TaN, may be provided on top of and in contact with the semiconductor material of the p-GaN gate structure 14. In embodiments, a gate metal 16a may also be deposited at the same time over the passivation layer 25 to form a lower field plate 21a connecting to the source 17. The gate metal 16, 16a may be deposited by conventional deposition methods, e.g., CVD, plasma vapor deposition (PVD), atomic layer deposition (ALD) and other techniques, and patterned by conventional etching processes, e.g., reactive ion etching (RIE), prior to the deposition of interlevel dielectric material 24 as shown in FIGS. 4C and 4D. The gate metal 16, 16a may be a refractory metal or its compound, e.g., titanium (Ti), titanium nitride (TiN), tantalum (Ta), tantalum nitride (TaN), palladium (Pd), tungsten (W), or tungsten silicide (WSi₂). As further disclosed herein, the lower field plate 21a will be self-aligned using the outer conductive spacer 23.

FIG. 1 further shows metal material 16b, 16c (metal material) and an optional metal layer (e.g., power metal) 16d. The metal material 16b, 16c, 16d includes an upper metal layer 16‴ (e.g., power metal at a first metal layer), and metal material 16b, 16c further include an ohmic contact 16' and a via 16" connecting the upper metal layer 16‴ to the ohmic contact 16'. The metal material 16b, 16c and metal layer 16d may be the same or different metal material as the gate metal 16, 16a. For example, the metal materials 16b, 16c, 16d may be aluminum (Al) or other conductive material used for wiring layers. In embodiments, the metal materials 16b, 16c, 16d may be deposited after patterning, e.g., lithography and etching processes, of the interlevel dielectric material 24 as shown in FIG. 4D. Additional interlevel dielectric layers 24a, 24b may also be deposited over the interlevel dielectric material 24 and gate metal 16, 16a. The ohmic contact 16c may connect to the drain region 19, e.g., barrier layer 12d; whereas the ohmic contact 16b embedded within interlevel dielectric material 24a and the optional metal layer 16d may be used as field plates 21b, 21c at different wiring levels, connecting to the source 17.

Although the field plates 21b, 21c may be formed from the metal material of the ohmic contact 16b and the metal layer 16d, it is also contemplated that the field plates 21b, 21c may be separate wiring layers which connect to the metal material 16b and the metal layer 16d. For example, in an optional embodiment, a metal wiring (e.g., TiN) may be used as a field plate 21b, connecting to the metal material 16b. Also, it should be understood that the thickness of the interlevel dielectric material 24 and passivation layer 25 between the field plates 21a, 21b, 21c and the passivation layer 20 can be used to reduce the electric field on the gate structure 14 due to depletion of the electric field on the drain side 19.

In embodiments, the passivation layers 20, 25 may be, for example, nitride material. In more specific embodiments, the passivation layer 20 may be silicon nitride, silicon oxide, or multiple materials, and may be deposited using ALD, CVD, or any other known deposition process; whereas the passivation layer 25 may be deposited over the outer conductive spacers 23 by ALD or CVD processes. In embodiments, the passivation layer 20 may be Al₂O₃ and the passivation layers 25 may be SiO₂ or Si₃N₄.

The passivation layer 20 may be located on an outer sidewall of the inner dielectric spacers 22 and over the semiconductor substrate 12, including at edges and a side of the active device 10, e.g., p-GaN gate structure. In this way, the inner dielectric spacer 22 is encapsulated between the passivation layer 20, passivation layer 14a, the pGaN gate structure 14 (on the bottom surface of the dielectric spacers 22) and the gate metal stack 16 (on an inner side and top surface). The inner dielectric spacers 22 may be a single layer or multiple layers of dielectric insulator material such as nitride, oxide or oxynitride as examples, and may be a different material than the passivation layers 14a, 20, 25.

Still referring to FIG. 1, the outer conductive spacers 23 may be formed on the passivation layer 20, opposing the inner dielectric spacers 22. The outer conductive spacers 23 may extend over the side and corners of the p-GaN gate structure 14. The outer conductive spacers 23 may be tungsten, polysilicon or tungsten silicide, as examples, and may be used to protect the gate structure 14 (e.g., p-GaN gate structure) during fabrication processes, e.g., etching processes to form the field plates. For example, the outer conductive spacers 23 will protect the passivation layer 20 during an etching process to form the metal material 16a (and field plate 21a) and metal material 16b and respective field plate 21b. In addition, the outer conductive spacers 23 may reduce stress on the gate structure 14 which otherwise results from different coefficients of expansion between the gate metal 16, 16a and gate structure 14. The outer conductive spacers 23 may also be self-aligned to the gate metal 16a on the gate side, as well as to an optional additional field plate 21a on the drain side.

As further shown in FIG. 1, in embodiments, the gate metal 16a is provided on the passivation layer 25 and may be self-aligned by the thickness of the outer conductive spacers 23. Also, the gate metal 16 provided on the p-GaN gate structure 14 may be self-aligned and surrounded by the inner dielectric spacers 22 and the outer conductive spacers 23. Moreover, the gate metal 16 may be symmetrically positioned over the active device 10 and surrounded by the inner dielectric spacers 22 and the outer conductive spacers 23, with an offset distance "X" from edges of the p-GaN gate structure 14. The offset distance "X" is a thickness of the inner dielectric spacers 22. Moreover, the profile of the gate metal 16 will following the profile of the inner dielectric spacers 22.

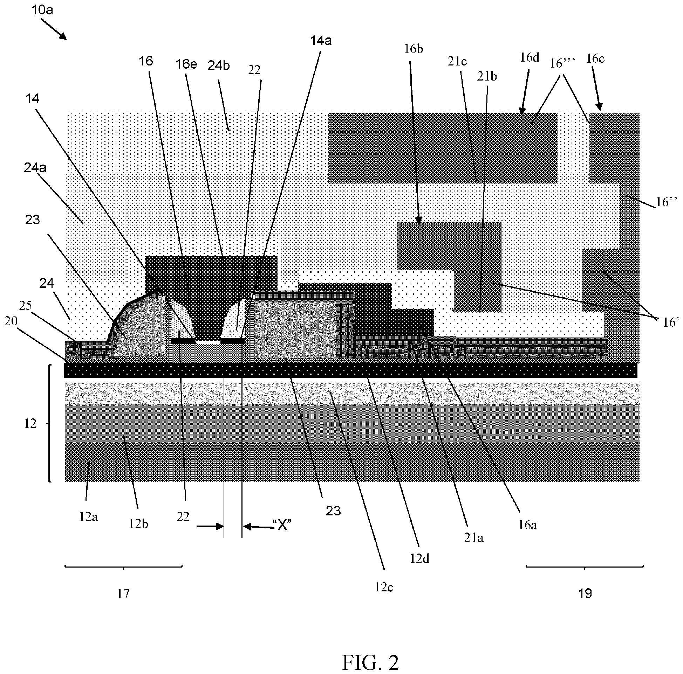

FIG. 2 shows a structure in accordance with additional aspects of the present disclosure. In the structure 10a of FIG. 2, the gate metal 16a extends over the outer conductive spacers 23. Also, the outer conductive spacers 23 further extend into the drift region, e.g., drain side 19 of the device. In this way, the field plate 21a comprising the outer conductive spacers 23 may have an extended length (compared to the structure shown in FIG. 1). The remaining features are similar to the structure 10 of FIG. 1.

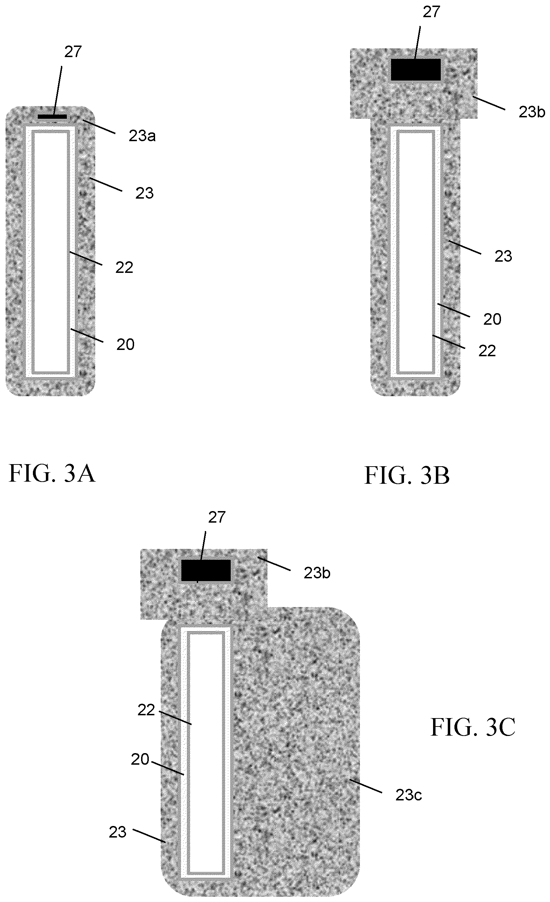

FIGS. 3A-3C show top views of the outer conductive spacers 23 in accordance with aspects of the present disclosure. The top views of the outer conductive spacers 23 shown in FIGS. 3A and 3B may correspond with the structure 10 shown in FIG. 1; whereas the top view of the outer conductive spacers 23 of FIG. 3C may correspond with the structure 10a shown in FIG. 2.

In the structure of FIG. 3A, the outer conductive spacers 23 include a narrow end portion 23a, with a contact 27 connecting to the narrow end portion 23a. In FIG. 3B, the outer conductive spacer 23 includes a wider (e.g., larger) end portion 23b, with a contact 27 connecting to the end portion 23b. The embodiment of FIG. 3B enables a larger landing space for the contact 27. FIG. 3C shows a top view of the outer conductive spacers 23 shown in FIG. 2, which has an extended length 23c within the drift region. The contact 27 may also be placed at the larger end portion 23b of the outer conductive spacers 23; although it is also contemplated that this structure includes the narrow end portion as shown in FIG. 3A.

FIGS. 4A-4D show respective fabrication processes for manufacturing the structure of FIG. 1 in accordance with aspects of the present disclosure. It should be understood by those of skill in the art that similar fabrication processes may be used to manufacture the structure of FIG. 2, with modifications to the patterning processes for the gate metal and field plates as should be understood by those of skill in the art.

As shown in FIG. 4A, the p-GaN gate structure 14 can be formed on the semiconductor substrate 12, e.g., patterned, using a hardmask 28. In embodiments, the hardmask 28 can be a nitride material or other hardmask material as is known in the art. For example, the p-GaN gate structure 14 may be formed by deposition of the p-GaN material on the substrate 12, followed by the deposition of a passivation layer 14a (etch stop) and the hardmask 28. The p-GaN material, passivation layer 14a and hardmask 28 can be patterned using conventional lithography and etching processes, e.g., reactive ion etching (RIE) as is known in the art.

The conventional lithography and etching processes include forming a resist over the hardmask material, which is exposed to energy (light) and developed by utilizing a conventional resist developer to form a pattern (opening). An etching process with a selective chemistry, e.g., reactive ion etching (RIE), will be used to transfer the pattern into the hardmask material and the p-GaN material to form the gate structure 14. The resist may be removed by a conventional oxygen ashing process or other known strips.

FIG. 4B shows the formation of the outer conductive spacers 23. To form the outer conductive spacers 23, the passivation layer 20 is formed over the patterned gate structure 14 and hardmask 28. In embodiments, the passivation layer 20 may be a nitride or oxide material (or combinations thereof) by ALD or CVD or other known process. An optional oxide material may be deposited on the passivation layer 20, depending on the desired thickness for a particular field plate design.

The outer conductive spacers 23 are formed by a conformal deposition of conductive material over the passivation layer 20, followed by an anisotropic etching process to form the outer conductive spacers 23. For example, tungsten, polysilicon or tungsten silicide material may be deposited on the structure using, for example, a CVD process. The material can be etched by an anisotropic etching process to form the outer conductive spacers 23. A passivation layer 25 may be deposited over the outer conductive spacers 23 and hardmask 28.

In FIG. 4C, inner dielectric spacers 22 are formed on sidewalls of trench 30. For example, the passivation layer 20, 25 over the hardmask and the hardmask, itself, may be selectively removed to form a trench 30, which exposes the underlying passivation layer 14a over the p-GaN gate structure 14. In embodiments, the passivation layer 14a will act as an etch stop layer to protect the p-GaN gate structure 14. As should be understood by those of skill in the art, the trench 30 will have sidewalls comprising the passivation layer 20.

The inner dielectric spacers 22 are formed on sidewalls of the trench 30 and, more specifically, over the passivation layers 14a, 20 within the trench 30. The spacer material may be, for example, oxide, nitride, oxynitride or other dielectric material or combinations thereof. In embodiments, the inner dielectric spacers 22 may be formed by conventional blanket deposition processes, e.g., CVD or ALD, etc., followed by an etch back process, e.g., anisotropic etching process, to remove the spacer material from a top surface of passivation layer 14a over the p-GaN gate structure 14. In this way, the inner dielectric spacers 22 are self-aligned to the edges of the p-GaN gate structure 14. Following the formation of the inner dielectric spacers 22, the exposed portions of the passivation layer 14a can be removed by a selective etching process to expose the underlying p-GaN gate structure 14.

As shown in FIG. 4D, the gate metal 16, 16a may be formed by deposition and patterning processes. In embodiments, the outer conductive spacers 23 will reduce stress on the gate structure when fabricating the gate metal 16, 16a, which can result due to different coefficients of expansion of the metal materials compared to the gate structure, etc., while also providing a self-aligning mechanism for the formation of at least bottom field plate 21.

By way of example, metal material may be blanket deposited (e.g., CVD) within the trench, formed in contact with the underlying p-GaN gate structure 14, in addition to over the passivation layer 25 outside of the trench. For example, the metal material will also be deposited over the inner dielectric spacers 22, outer conductive spacers 23 and passivation layer 25, followed by a conventional patterning process to form any of the different configurations shown in FIGS. 1 and 2.

It should thus be recognized that a patterning process may be used to form the field plate 21a from the gate metal 16a. As should be understood, the gate metal 16 will be self-aligned to the p-GaN gate structure 14, and will also be offset from the edges of the p-GaN gate structure 14 by the inner dielectric spacers 22, while the gate metal 16a will be self-aligned to the outer conductive spacer 23.

The process flow continues with conventional back end of the line (BEOL) processes as described with respect to FIG. 1, with the outer conductive spacers 23 protecting the p-GaN gate structure 14 during additional fabrication process of, for example, the field plates and the ohmic contacts. By way of example, interlevel dielectric material 24 may be deposited over the gate metal 16, 16a, followed by a patterning process to form the different patterns including pattern 29 shown in FIG. 4D within the interlevel dielectric material 24, which conform to the shape of the metal material 16b, 16c as shown in FIGS. 1 and 2. The metal material on the drain side 19 can be deposited within the patterned interlevel dielectric material 24. This same process can be repeated for each different field plate at different levels of the device as should be understood by those of skill in the art.

The HEMT can be utilized as a single device in discrete applications, may be combined in a single package with several other devices of the same or varying types via co-packaging or multi-chip 3D integration techniques, or may be combined with several other devices in system on chip (SoC) technology. The SoC is an integrated circuit (also known as a "chip") that integrates all components of an electronic system on a single chip or substrate. As the components are integrated on a single substrate, SoCs consume much less power and take up much less area than multi-chip designs with equivalent functionality. Because of this, SoCs are becoming the dominant force in the mobile computing (such as in Smartphones) and edge computing markets. SoC is also used in embedded systems and the Internet of Things. Moreover, GaN devices are increasingly being employed in SoC designs where multiple GaN HEMTs are formed on a single substrate.

The method(s) as described above is used in the fabrication of discrete device chips or integrated circuit chips. The resulting chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a central processor.

The descriptions of the various embodiments of the present disclosure have been presented for purposes of illustration, but are not intended to be exhaustive or limited to the embodiments disclosed. Many modifications and variations will be apparent to those of ordinary skill in the art without departing from the scope and spirit of the described embodiments. The terminology used herein was chosen to best explain the principles of the embodiments, the practical application or technical improvement over technologies found in the marketplace, or to enable others of ordinary skill in the art to understand the embodiments disclosed herein.

## Claims

1. A structure comprising:
a gate structure;
a gate metal connecting to the gate structure;
inner spacers contacting and surrounding the gate metal;
a passivation layer on the inner spacers; and
outer conductive spacers on the passivation layer and adjacent to sides of the gate structure.

2. The structure of claim 1, wherein the gate structure comprises p-GaN material.

3. The structure of claim 1 or claim 2, wherein the inner spacers comprise dielectric material.

4. The structure of one of claims 1 to 3, wherein the passivation layer is a nitride material between the inner spacers and the outer conductive spacers.

5. The structure of one of claims 1 to 4, wherein the outer conductive spacers surround the gate structure and the gate metal, and/or wherein the outer conductive spacers comprise a field plate connected to a source.

6. The structure of claim 5, further comprising additional gate metal adjacent to the outer conductive spacers on a drain side, the additional gate metal comprising a second field plate connecting to the source.

7. The structure of claim 6, further comprising metal material on the drain side, and, optionally, wherein the metal material comprises at least another field plate above the second field plate abutting the outer conductive spacers on the drain side.

8. The structure of claim 7, wherein the other field plate, the first field plate and the second field plate are at different levels.

9. The structure of one of claims 1 to 8, wherein the outer conductive spacers comprise a lower field plate with an extended length into a drift region on a drain side and connecting to a source, and further comprising a gate metal comprising a second field adjacent to the outer conductive spacers and connecting to the source.

10. A structure, comprising:
a gate structure;
inner dielectric spacers;
outer conductive spacers surrounding the inner dielectric spacers;
a gate metal connecting to the gate structure and surrounded by the inner dielectric spacers, the gate metal also being adjacent to the outer conductive spacers on an opposing side from the inner dielectric spacers.

11. The structure of claim 10, further comprising:
an insulator material isolating the outer conductive spacers from the gate metal adjacent to the outer conductive spacers; and/or
a passivation layer between the outer conductive spacers and the inner dielectric spacers.

12. The structure of claim 11, wherein the outer conductive spacers comprise a first field plate on the passivation layer and the gate metal adjacent to the outer conductive spacers comprises a second field plate on the insulator material, and, optionally, wherein the gate metal adjacent to the outer conductive spacers abuts the outer conductive sidewall spacers, with the insulator material between the gate metal and the outer conductive spacers.

13. The structure of claim 12, further comprising at least one additional field plate comprising an ohmic contacts on a drain side of the device.

14. The structure of one of claims 10 to 13, wherein the outer conductive spacers comprise a length extending into a drift region on a drain side of the device, and/or wherein the gate metal connecting to the gate structure and the gate metal adjacent to the outer conductive spacers comprise a same metal material.

15. A method comprising:
forming a gate structure;
forming a gate metal connecting to the gate structure;
forming inner spacers contacting and surrounding the gate metal;
forming a passivation layer on the inner sidewall spacers; and
forming outer conductive spacers on the passivation layer and adjacent to sides of the gate structure.
